Europäisches Patentamt

European Patent Office

Office européen des brevets

(19)

(11) Veröffentlichungsnummer: **0 210 606**
**A2**

## (12) EUROPÄISCHE PATENTANMELDUNG

(21) Anmeldenummer: 86110259.8

(22) Anmeldetag: 25.07.86

(51) Int. Cl.⁴: **H03H 7/48**

(30) Priorität: 01.08.85 DE 3527555

(43) Veröffentlichungstag der Anmeldung:
04.02.87 Patentblatt 87/06

(84) Benannte Vertragsstaaten:
**DE FR GB IT**

(71) Anmelder: **Rohde & Schwarz GmbH & Co. KG**
**Mühldorfstrasse 15**
**D-8000 München 80(DE)**

(72) Erfinder: **Bauer, Helmut**
**Buchenweg 10**
**D-8134 Niederpöcking(DE)**

(74) Vertreter: **Graf, Walter**
**Sckellstrasse 1**
**D-8000 München 80(DE)**

(54) Schaltung zum entkoppelten Zusammenführen der Ausgangsleistungen mehrerer Hochfrequenz-Leistungssender.

(57) Zum Zusammenführen der Ausgangsleistung mehrerer Hochfrequenz-Leistungssender mittels eines Wilkinson-Kopplers sind dessen konzentrierte Bauelemente so dimensioniert, dass sie gleichzeitig als Hochfrequenzfilter wirken.

EP 0 210 606 A2

## Schaltung zum entkoppelten Zusammenführen der Ausgangsleistungen mehrerer Hochfrequenz-Leistungssender

Die Erfindung betrifft eine Schaltung laut Oberbegriff des Hauptanspruches.

Zum entkoppelten Zusammenführen der Ausgangsleistung von mehreren auf gleicher Frequenz arbeitenden Hochfrequenz-Leistungssendern ist es bekannt, sogenannte Wilkinson-Koppler zu verwenden (DE-PS 27 33 888). Solche Wilkinson-Koppler besitzen die vorteilhafte Eigenschaft, dass die Ausgänge der zusammenzuschaltenden Hochfrequenz-Leistungssender relativ breitbandig mit dem idealen Arbeitswiderstand von beispielsweise 50 Ohm abgeschlossen sind, also ideale Anpassung besteht, und trotzdem die einzelnen Ausgänge dieser Leistungssender vollständig voneinander entkoppelt sind. Diese Wilkinson-Koppler werden im einfachsten Fall aus zwei oder mehreren parallelgeschalteten $\lambda/4$ langen Leitungsstücken aufgebaut ($\lambda$ = mittlere Betriebswellenlänge) an deren einem Eingang jeweils die zusammenzuschaltenden Leistungssender angeschlossen sind und die am anderen Ende in einem freien Sternpunkt zusammengefasst sind, der mit der zu speisenden Last, beispielsweise der Antenne, verbunden ist. An den mit den Leistungssendern verbundenen Enden sind Entkopplungswiderstände angeschaltet. Der Wellen widerstand dieser Leitungsstücke bemisst sich nach der Anzahl der zusammenzuführenden Leistungssender, bei nur zwei Leistungssendern werden beispielsweise $\lambda/4$ lange Leitungsstücke vom Wellenwiderstand $Z = \sqrt{2 \cdot Z}$ benutzt. Um solche Wilkinson-Koppler breitbandiger zu machen, könnten auch mehrere solche aus Leitungsstücken aufgebaute Transformationsglieder in Kette hintereinander geschaltet werden, wobei es vorteilhaft ist, hierfür ein allen vorhergehenden . parallelgeschalteten Leitungsstücken gemeinsames Leitungsstück nachzuschalten, um den Aufbau zu vereinfachen (nach DE-PS 27 33 888). Es ist auch bekannt, solche wilkinson-Koppler ganz oder teilweise aus konzentrierten Bauelementen (Spulen und Kondensatoren) aufzubauen, und zwar nach den bekannten Regeln der Äquivalenz zwischen elektrischen Leitungen und LC-Schaltungen.

Bei Hochfrequenz-Leistungssendern dieser Art besteht zusätzlich noch das Problem der Unterdrückung von harmonischen Oberwellen. Es ist daher auch schon bekannt, zwischen den einzelnen zusammenzuschaltenden Hochfrequenz-Leistungssendern und den Eingängen des Wilkinson-Kopplers zusätzliche Oberwellenfilter zwischenzuschalten, die in herkömmlicher Weise aus konzentrierten Bauelementen (Spulen und Kondensatoren) aufgebaut sind und deren Eingangswiderstand im allgemeinen gleich dem Ausgangswiderstand der Leistungssender im Betriebsfrequenzbereich, bei einem UKW-Sender also beispielsweise im Frequenzbereich von 87 bis 108 MHz, gewählt ist. Diese Oberwellenfilter sind im einfachsten Fall Tiefpassfilter, können jedoch gegebenenfalls auch als Bandpassfilter ausgeführt sein.

Es ist Aufgabe der Erfindung, den Aufbau einer solchen aus einem Wilkinson-Koppler mit zusätzlichen Oberwellenfiltern aufgebauten Schaltung zum entkoppelten Zusammenführen der Ausgangsleistungen mehrerer Hochfrequenz-Leistungssender zu vereinfachen und zu verbilligen.

Diese Aufgabe wird ausgehend von einer Schaltung laut Oberbegriff des Patentanspruches durch dessen kennzeichnende Merkmale gelöst.

Bei Frequenzweichen zum entkoppelten Zusammenführen von Hochfr quenzspannungsquellen unterschiedlicher Frequenz (DE-OS 30 27 235) oder zum Aufspalten eines breiten Frequenzbandes in voneinander getrennte Frequenzbereiche (DE-OS 32 28 449) ist es bekannt, einzelne Bauelemente des einen Weichenzweiges zugleich in dem auf anderer Frequenz arbeitenden anderen Weichenzweig wirken zu lassen, um so Bauelemente zu sparen. Die Erfindung geht zur Lösung der oben erwähnten Aufgabe noch einen Schritt weiter und - schlägt vor, die für die gleiche Arbeitsfrequenz dimensionierten Transformationsglieder eines Wilkinson-Kopplers insgesamt so aus konzentrierten Bauelementen aufzubauen und zu dimensionieren, dass jedes dieser auf gleicher Frequenz arbeitenden Zweige gleichzeitig als Wilkinson-Transformationsglieder und gleichzeitig als Oberwellenfilter wirken, jedes Glied also jeweils zwei wirkungsmässig unterschiedliche Schaltungen in sich vereint. Gemäss der Erfindung sind die den auf gleicher Frequenz arbeitenden Leistungssendern zugeordneten Oberwellenfilter also unmittelbar in den Wilkinson-Koppler schaltungstechnisch integriert und es werden sämtliche für das Transformationsglied des Wilkinson-Teilers vorgesehenen Bauelemente gleichzeitig für die Realisierung der Oberwellenfilter ausgenutzt. Dadurch wird der Gesamtaufbau einer solche Schaltung sehr einfach und billig, was vor allem bei hohen Senderleistungen mit den damit bedingten gross dimensionierten Bauelementen von grossem Vorteil ist. Durch entsprechende Wahl der Schaltung und Dimensionierung der verwendeten konzentrierten Bauelemente in den einzelnen Transformationszweigen des Wilkinson-Kopplers können die verschiedenartigsten Filterschaltungen wie Tiefpässe, Hochpässe oder auch Bandpässe realisiert werden, und zwar in bekannter Weise mit beliebigen Dämpfungsverläufen. Im Prinzip sind für den erfindungsgemässen Zweck alle bekannten Filterschaltungen geeignet, soweit sie schaltungstechnisch gleichzeitig auch zur Realisierung der Transformationsglieder des Wilkinson-Kopplers geeignet sind.

Der eigentliche Wilkinson-Koppler kann in bekannter Weise ein oder mehrstufig aufgebaut werden, je nach den gewünschten Breitbandeigenschaften der Schaltung. Bei einem nur einstufigen Wilkinson-Koppler ist es vorteilhaft, jedes einzelne der parallelgeschalteten Transformationsglieder, bei nur zwei zusammengeführten Leistungssendern also die beiden vorgesehenen Transformationsglieder, im Sinne der Erfindung gleichzeitig als Oberwellenfilter zu dimensionieren. Bei einem mehrstufigen Wilkinson-Koppler, bei dem beispielsweise allen vorhergehenden parallelgeschalteten Transformationsgliedern ein weiteres gemeinsames Transformationsglied nachgeschaltet ist (nach DE-PS 27 33 888) kann es vorteilhaft sein, nur dieses zusätzliche Transformationsglied im Sinne der Erfindung als Oberwellenfilter zu dimensionieren, da dieses ja auch gemeinsam auf die Ausgänge der zusammenzuführenden Leistungssender wirkt. In diesem Fall können die vorhergehenden parallelgeschalteten Transformationsglieder gegebenenfalls in bekannter Weise wieder durch Leitungsstücke realisiert werden.

Die Erfindung wird im folgenden anhand einer schematischen Zeichnung an zwei Ausführungsbeispielen näher erläutert.

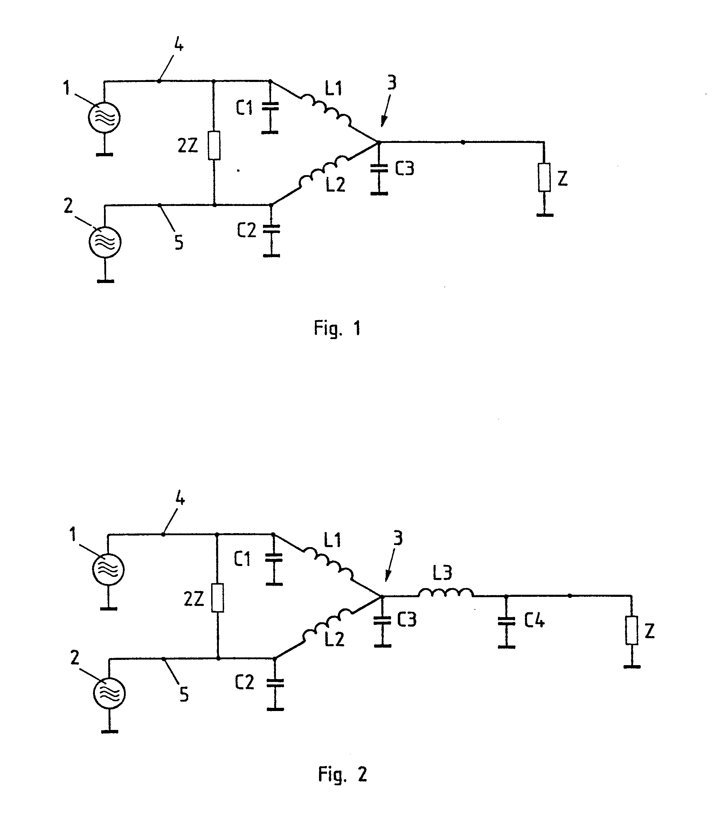

Figur 1 zeigt das Prinzipschaltbild einer Schaltung zum entkoppelten Zusammenführen der Ausgangsleistungen von zwei auf gleicher Frequenz beispielsweise im UKW Frequenzband von 87 bis 108 MHz arbeitenden Hochfrequenz-Leistungssendern 1 und 2 mittels eines vollständig aus konzentrierten Bauelementen (Kondensatoren C und Spulen L) aufgebauten Wilkinson-Kopplers 3. Die Ausgänge 4 und 5 der Leistungssender 1, 2 sind jeweils mit den Eingängen von zwei parallelgeschalteten Transformationsgliedern des Wilkinson-Kopplers 3 verbunden, das eine Transformationsglied wird in dem gezeigten Beispiel durch ein als Tiefpass geschaltetes $\pi$-Glied C1, L1, C3 gebildet, das andere Transformationsglied durch das $\pi$-Glied C2, L2, C3. Diese $\pi$-Glieder sind in bekannter Weise so dimensioniert, dass sie einerseits die für den Wilkinson-Koppler gewünschte Widerstandstransformation des Lastwiderstandes 2Z pro Glied am Ausgang in den Widerstand Z am Eingang, wo in bekannter Weise der Entkopplungswiderstand 2Z angeschaltet ist, bewirken (und hierbei der Eingangswiderstand für jeden einzelnen Ausgang 4 bzw. 5 weiterhin Z ist) und andererseits diese $\pi$-Glieder gleichzeitig als Oberwellenfilter, beispielsweise als Tiefpass, wirken. Durch geeignete Dimensionierung dieser $\pi$-Glieder ist damit beispielsweise für einen UKW Sender erreichbar, dass der Eingangswiderstand dieser als Wilkinson-Koppler wirkenden $\pi$-Glieder breitbandig im Frequenzbereich zwischen 87 und 108 MHz breitbandig Z und die Dämpfung null ist, über 108 MHz dagegen zunehmend Fehlanpassung auftritt und die Dämpfung stark anwächst. Auf diese Weise können also beispielsweise die Ausgangsleistungen von zwei 2,5 KW-Sendern gleicher Frequenz zu einer gewünschten Gesamtleistung von 5 KW zusammengeführt werden.

Der Wilkinson-Koppler kann in bekannter Weise auch mehrstufig ausgebildet sein, wie dies Fig.2 zeigt. Hier ist den beiden parallelgeschalteten Transformations-$\pi$-Gliedern noch ein weiteres Transformations-$\pi$-Glied C3, L3, C4 nachgeschaltet. Auch dieses $\pi$-Glied ist wieder gleichzeitig als Transformations-und Filter-Glied dimensioniert. Bei diesem mehrstufigen Wilkinson-Koppler könnten die dem als Filter wirkenden $\pi$-Glied C3, L3, C4 vorgeschalteten Transformationsglieder gegebenenfalls auch wieder in bekannter Weise durch Leitungsglieder realisiert sein, da es genügt, wenn das den beiden Leistungssendern 1, 2 gemeinsame Transformationsglied C3, L3, C4 als Oberwellenfilter wirkt.

**Ansprüche**

Schaltung zum entkoppelten Zusammenführen der Ausgangsleistungen von mehreren mit gleicher Frequenz arbeitenden Hochfrequenz-Leistungssendern mittels eines Wilkinson-Kopplers, dessen Transformationsglieder mindestens teilweise aus konzentrierten Bauelementen aufgebaut sind, dadurch **gekennzeichnet**, dass die Bauelemente mindestens eines der Transformationsglieder (C1, L1, C3; C2, L2, C3; C3, L3, C4) des Wilkinson-Kopplers (3) in der Art einer bekannten Filterschaltung (z.B. $\pi$-Glied) angeordnet sind und so dimensioniert sind, dass sie gleichzeitig als Hochfrequenzfilter (Tiefpass, Hochpass oder Bandpass) wirken.

Fig. 1

Fig. 2